(19) Europäisches Patentamt
European Patent Office
Office européen des brevets

(11) **EP 1 014 526 B1**

(12) **EUROPEAN PATENT SPECIFICATION**

(45) Date of publication and mention
of the grant of the patent:
**26.05.2010 Bulletin 2010/21**

(51) Int Cl.:
*H02H 3/06* *(2006.01)* *H02H 7/26* *(2006.01)*

(21) Application number: **99660191.0**

(22) Date of filing: **16.12.1999**

(54) **Method in connection with protective relay and protective relay**

Verfahren im Zusammenhang mit Schutzrelais und Schutzrelais

Procédé associé au relais de protection et relais de protection

(84) Designated Contracting States:
**DE FR GB**

(30) Priority: **17.12.1998 FI 982741**

(43) Date of publication of application:
**28.06.2000 Bulletin 2000/26**

(60) Divisional application:
**08159973.0 / 1 981 141**

(73) Proprietor: **ABB Oy**
**00380 Helsinki (FI)**

(72) Inventor: **Kuisti, Harri**
**02720 Espoo (FI)**

(74) Representative: **Peltonen, Antti Sakari et al**
**Kolster Oy Ab**
**Iso Roobertinkatu 23**
**P.O. Box 148**
**00121 Helsinki (FI)**

(56) References cited:
**US-A- 4 710 841**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### BACKGROUND OF THE INVENTION

The present invention relates to a method and protective relay according to the preambles of the independent claims.

To minimise feed disconnections caused by faults in the electrical power network the known solutions often include a so-called auto-reclosing relaying which recloses a switch a while after it has opened. Since most of the faults in an open-wire network are electric arc faults, which disappear when the faulty line is disconnected for a short time, the distribution of electricity can often be continued by means of auto-reclosing. One disadvantage is that sometimes the fault does not disappear when the switch is open. Then the switch is closed against the fault and new relay operation and the opening of the switch are required immediately. In such a case, it is useful to know when the disconnecting of the line has led into the elimination of the fault, so that unnecessary auto-reclosings can be avoided.

Another disadvantage of auto-reclosings concern risk factors relating to them. It is always possible that a man, in one way or another, becomes affected by the earth fault, whereby the recharging of the faulty line may be dangerous. Also in short circuits a ground contact and a risk of human accidents may be concerned. The elimination of a ground contact would thus improve security also in short circuits. In the known solutions, auto-reclosings must be made without knowing whether the fault is eliminated. As a result, unsuccessful auto-reclosings and human accidents often occur.

Sometimes the line comprises a small-scale power station for decentralized power feed. Then, voltages behind the switch do not essentially change when the switch opens. The small-scale power station can then continue to feed the fault also when the switch of the line is open. Since the small-scale power station cannot feed fault current as much as the whole network, there are better chances for the fault to disappear by itself when the line switch has opened. This is the case particularly in the earth fault. In many cases it is thus convenient to keep the small-scale power station behind the open switch in operation for some time, whereby the probability of the disappearance of the fault by itself grows. In the best case the fault disappears and the consumers on the line are not left without electricity for one moment. The problem is then to recognise when the fault disappears from the line.

A busbar, line or line arm at substations, switching substations and disconnector satellite substations can often get feed from two or more directions to their. If an earth fault occurs in the network, and none of the protective relays or fault indicators of the line or line arm indicates that the fault is on a specific line or line arm, it can be concluded that the fault is on the feed side. Then, the feed switch is usually opened and the switch of another feed is closed. There is a danger, however, that the fault is between the feed switch and the line switch, i.e. on the busbar of a substation or switching station or inside a disconnector satellite substation. Therefore, when the feed is changed, it is important to be able to detect on which side of the opened feed switch the fault is and not to close the switch of another feed, if the fault is on the busbar or inside the disconnector satellite substation.

In the distribution network there are usually consumers of electricity along the line, who all miss the feed as a result of relay operation in the beginning of the feed line. When it comes to a permanent fault, the problem is to recognise between which disconnectors the fault is, so that the line section concerned could be disconnected from the network and the feed could be returned to the other parts of the network.

If the line comprises a capacitor battery, the opening of the line switch may cause resonance to the line. The resonance frequency depends on the values of the total capacitance and total inductance of the line. Resonance may cause overvoltages to the line and damage the components on the line. It is important that such a resonance is recognised so that the network topology can be selected such that resonances do not occur when the lines and line sections are disconnected. Traditionally there have been no methods to achieve this purpose, since voltages have not usually been measured from the disconnected lines in the distribution network.

Traditional solutions include pre-set lengths for the times the switch is open, i.e. the 'dead times' of auto-reclosing sequences. For example, the switch can at first be held open for a short time, e.g. 150 ms, and then the auto-reclosing can be made. It the fault is eliminated by this so-called high speed automatic reclosing, the switch can be held closed and the power distribution can be continued as usual. If the line still has the fault, the switch is reopened for a longer time, e.g. for 1 minute. Then the switch is closed again. If the fault is eliminated by this so-called delayed auto-reclosing, the switch can be held closed and the power distribution can be continued as usual. Otherwise the relay trips the line definitively out of the network and it is set out to find the fault. There are different variations of the simple auto-reclosing sequence described above; however, they all have a common feature that the lengths of the dead times are set in advance.

Different practices based on experience have developed concerning the traditionally used lengths of dead times. The length of dead time in high speed automatic reclosing usually equals about few hundreds of milliseconds and the length of dead time in delayed auto-reclosing few minutes.

The voltage on the line behind the open switch, which voltage is caused by motor loads on the line, has not traditionally been taken into account in any other ways but with sufficiently long dead times of auto-reclosing. The problem is to detect when the fault has been eliminated.

In the feed change, the location of the fault is traditionally concluded by means of an over-current criterion: if it is detected that fault current flows through the opening switch, the fault is concluded to be located behind the switch. Then the closing of another feed switch is prevented as it would lead to a connection against the fault.

The publications Gardiner M., Ramsden J.: On-Site Experience of an Adaptive Autoreclosure Relay for HV Overhead Lines, Developments in Power System Protection, 25-27th March 1997, Conference Publication No. 434, IEE, 1997, p. 377-380 and Laycock W.J.: Adaptive Reclosure of HV Overhead Lines, p. 471-474, IEEE Transmission and Distribution Conference Proceedings, 1996 introduce a method of improving single-phase auto-reclosings connected to phase-to-earth faults of the transmission network. The method of the publications cannot be applied to most distribution and transmission networks as usually the switches have a three-phase operation.

The method of the publications also has the disadvantage that the detection of the quenching of an electric arc is not based on unambiguous and exact criteria. The use of neural network technology is thus suggested in the publications. This has the disadvantage that according to the operational principle of neural networks the operation is partly unanticipated. The instructing of the neural network is a demanding task as well, and the neural network instructed by the voltage recordings of one electrical power network does not necessarily operate optimally in another network.

The publication Bo Z. Q.: A new approach to distinguish between transient and permanent faults using high frequency fault transients, 3rd International Conference on Advances in Power System Control, Operation and Management, Conf. Publ. No CP417, Hong Kong 9.-11.11.1994, IEE 1995 describes a method by which it can be detected whether the fault of a transmission network is an electric arc fault or a permanent fault. In the method of the publication, high-frequency voltage signals caused by an electric arc fault are utilized. If the switch opens in three phases, the electric arc fault can be distinguished from the permanent fault by means of the measurements taken before the opening of the switch. On the other hand, if the switch opens in a single phase, the electric arc fault and its disappearance can be detected by measuring the voltage of the faulty phase behind the opened switch.

The solution of the above publication requires special equipment so that voltages with a frequency of dozens of kilohertz can be measured. In connection with a three-phase auto-reclosing, the publication suggests the classification of faults into permanent faults and electric arc faults before the switch opens. In the observed transmission line the fault disappears immediately after the line has been disconnected from the network in three phases. However, rotating machines functioning as loads in the distribution network generate alternating voltages that may maintain the electric arc also during the dead time of the three-phase auto-reclosing.

The publication Thorn J.S.: Feasibility of adaptive protection and control, IEEE Transactions on Power Delivery, Vol. 8, No. 3, July 1993, p. 975-983 introduces ideas about single-phase auto-reclosings and how these ideas improve the chances of successful auto-reclosings. The publication mentions that the disappearance of an earth fault can be detected on the basis of a steep growth in the phase voltage. Only after it is detected that the earth fault has disappeared the auto-reclosing is made. The article explains that the same criterion applies to a three-phase switch function as well, since electric charge remains in the phases when the switch opens. The remaining charge discharges and maintains the electric arc, and after the electric arc quenches, the voltage of the faulty phase suddenly increases.

The method and its theoretical basis described in the publication cannot as such be applied to a medium-voltage distribution line, along which there are usually distribution power transformers. The charge remaining in the earth capacitances of the phases is rapidly balanced through primary windings of the distribution power transformers. In case of an earth fault of a medium-voltage distribution line, when the fault disappears, the voltage of the faulty phase does not usually increase, which would require that the voltages of the healthy phases have a higher potential before the disappearance of the fault so that the disappearance of the fault would lead to the balancing of the potentials between different phases and to the increase in the voltage of the faulty phase.

The voltage of the faulty phase of a medium-voltage distribution line may also rise, but only when the line has enough motor load or generators that are connected to a decentralized power feed and that induce a three-phase alternating voltage to the line, while the switch is open. Even when the line has motor load, the voltage of the faulty phase does not necessarily rise. This is because the amplitude of the three-phase voltage induced by the motors often decreases rapidly, whereby the voltage increase of the faulty phase that is otherwise caused by the elimination of the fault is cancelled as a result of a general decrease of voltages.

Another method described in the publication is based on the switch opened in three phases being closed in such a manner that one phase is closed at first. Thus, voltages are induced also to the open phases. If it is detected that the voltages of the two phases follow each other, it can be concluded that there is a short circuit and a three-phase auto-reclosing is not made. Thus, the purpose of this method is not to detect the disappearance time of the fault during the dead time of the auto-reclosing but to ensure the disappearance of the fault only when making the auto-reclosing.

Patent SU 607305 A 19780424 introduces a method, in which the length of the dead time of the auto-reclosing is determined by the amount of power transferred through the line before the fault. The higher the transferred power, the shorter a dead time is set for the auto-reclosing. This does not naturally make the fault to disappear more easily but aims at improving the stability of the network.

The method of Patent US 5,805,400 determines the length of the dead time of an auto-reclosing in such a manner that the margin between the operational point and the point where the stability is losed is taken into account, so that the danger of losing stability can be minimised when making the auto-reclosing.

Patent US 5,543,995 introduces a method, by which the breaking of a conductor of a transmission line can be detected by estimating the voltage of the faulty section by means of voltage and current measurements taken from both ends of the line and the auto-reclosing can be prevented, if a break in the conductor is detected. By this method, the disappearance of short circuit and earth faults cannot be detected when the line is disconnected from the net-work.

A variety of known methods are used to disconnect a faulty section from a distribution line. One method is to calculate the location of the fault in the network by means of the measurements taken from the beginning of the line and to disconnect the faulty line section with remote-controlled disconnectors. As there is not usually sufficiently fast communication available, the faulty line section cannot be disconnected from the network during the dead time of the high speed automatic reclosing.

Another known method of disconnecting a faulty line section is to apply switches along the line, which utilize local logic. The switches open when the voltage exits during the dead time of the high speed automatic reclosing and close again as the voltage returns. First the switch nearest to the fault closes and after that the switches behind it close one by one. As the switch located immediately before the fault section closes, fault current starts to flow again, and this causes the relay at the beginning of the line to trip and the switch which closed the last to lock open. In the next auto-reclosing other switches close, and the distribution of electricity is returned to that section of the line which is not faulty.

A drawback of the known solutions is that before the switch is closed, usually nothing is known about the elimination of the fault. In order for the probability of eliminating the fault to be as high as possible, dead time cannot be determined to be very short, so that the voltages generated by loading motors would have enough time to damp on the line and the ionisation caused by the electric arc would have enough time to exit from the faulty section. On the other hand, longer dead times usually cause more harm to consumers of electricity. In practice, compromises have to be made between different opinions when selecting the length of dead time, which leads to unsuccessful auto-reclosings, on one hand, and also unnecessary switch controls, as the fault has not have time to disappear before the switch is closed. On the other hand, the distribution interruption may also be far too long for the disappearance of the fault, if the fault disappears soon after the switch has been opened.

A drawback of the traditional solutions is also that the disappearance of the fault depends on the load of the line. If there are several motors as load, the voltage on the line may remain the same a long time after the switch has opened, which weakens the chances of the fault to disappear. Sometimes loads may be mainly heating or lighting loads, which do not maintain the voltage behind the switch. In the latter case, the switch could thus be reclosed faster, but in the traditional solutions, the features of the loading cannot be taken into account this way.

A line may also comprise generators connected to a decentralized power feed, which may maintain voltage and thus prevent the fault from disappearing. As an example, a wind power station can be mentioned, whose operation depends naturally on wind conditions, and the chances of the fault to disappear by itself may vary considerably according to the situation. The traditional solutions cannot take this kind of situation into account.

The traditional solution in which a small-scale power station on a line is immediately disconnected when the line switch opens, means in many cases an unnecessary interruption of power distribution for the consumers along the line. By means of the traditional solution, a possible disappearance of the fault by itself after the switch has opened cannot be utilized.

By means of the traditional feed change logic, the closing of another feed switch is prevented, if it is detected that fault current has passed through the opened switch. This method is not comprehensive, since it is possible that the fault is located between the opening switch and the measuring point of current. Then the fault current is not detected but the fault, however, is not eliminated by opening the switch. Another feed switch is then closed against the fault, which is naturally harmful. The reliability of the solution based on the use of the overcurrent criterion depends also on whether the locking message sent by the device measuring overcurrent arrives at the feed changing device. If the locking message does not arrive there, the switch of another feed is closed against the fault with harmful effects.

Said method of auto-reclosing based on measuring voltage includes the following weaknesses. The method is based on measuring the frequency content of the voltage of a faulty phase and instructing a neural network to recognise the disappearance of a so-called secondary electric arc that is lit at the phase disconnected from the network. A secondary electric arc is caused by the fact that through the capacitance between the phases, an alternating voltage is connected to the phase disconnected from the network. The method is only applicable to a phase-to-earth fault and cannot be employed in three-phase auto-reclosings.

The methods of the above publications relate to auto-reclosings of a transmission network and they do not handle the effect of loading motors typical of distribution networks.

None of the publications gives a solution in which voltages induced by rotating machines functioning as loads are taken into account when making auto-reclosings, which is due to the fact that the publications deal with auto-reclosings of the transmission network, and transmission lines do not have rotating machines as loads.

The publications do not introduce methods which are applicable to a distribution network and by which a faulty section can be disonnected by means of disconnectors on the line, nor solutions are given for detecting a rapid feed change on a substation or a disconnector satellite substation located on the line.

A drawback of the traditionally used methods of disconnecting a faulty section of a transmission line is the slowness. The solution based on fault location and remote-controlled disconnectors requires a communication connection from the disconnectors to a substation or a control room. The building of a signalling system to all disconnector satellite substations is, however, expensive. In addition, the accuracy of the fault distance calculation depends on many factors, e.g. on the measurement accuracy of currents and voltages and the accuracy of the line parameters used in the calculation. It is thus in practice possible that a faulty section between disconnectors cannot be located properly.

The solutions based on local logic for disconnecting a faulty line section do not require a fast communication, but as the locating of the faulty section is based on phased test connections of disconnectors and on another relay opeartion resulting thereof, a fairly long interruption in the distribution of electricity cannot be avoided. The solutions based on local logic have traditionally only been applied in delayed auto-reclosing, if the fault has not disappeared by means of a high speed automatic reclosing.

BRIEF DESCRIPTION OF THE INVENTION

The object of the present invention is to provide a method by which the above drawbacks can be avoided and to enable the implementation of auto-reclosings and feed changes in a more reliable way. This object is achieved by the method of the invention, which method is characterized by further comprising the steps of: measuring voltages from the disconnected line, line section or busbar in three phases, forming parameters describing the state of the disconnected line, line section or busbar from the measured voltages, and concluding, on the basis of the parameters, the disappearance or possibility of disappearance of the fault of the disconnected line, line section or busbar.

The invention is based on the idea that when the feed is switched off from the line or line section, the line or line section does not immediately become dead, but the motors loading the line function as generators inducing alternating voltages to the line.

The invention enables the detection of the disappearance or existence of the fault, while the switch is open in three phases. Then if the fault disappears and the switch is opened, the length of dead time can be rapidly minimised. If it deals with a permanent fault or a fault which disappears slowly, the switch can be held open longer. The drawback of the traditional solution of having to compromise when the length of dead time is set is avoided since the length of dead time is set according to the fault in question and not on the basis of statistical observations or experience.

By means of the solution of the invention, the disappearance of the fault by itself can also be utilized in a situation in which the line comprises a small-scale power station. The small-scale power station need not be immediately switched off when the line switch opens, but it can be waited until the fault has disappeared. If the fault disappears by itself, interruptions in the power distribution can be avoided.

By means of the invention, unnecessary auto-reclosing attempts can also be prevented in situations in which electric machines on the line maintain the voltage on the line and prevent the fault from disappearing.

In connection with a feed change, the invention enables the detection of the location of the fault on a busbar or inside a disconnector satellite substation also in cases in which it is located between the switch and the measuring point of current. The solution of the invention also improves the reliability of the feed change automatics, as the operation no longer depends on the locking message, indispensable in the traditional solution, coming from the over-current relay of the feed.

By means of the invention it is possible to recognise the resonance and its frequency behind the opened switch, whereby the network topology can be changed in order to avoid resonance in the future.

The solution of the invention is implemented by means of the measurements of signals which have either a fundamental frequency or a lower frequency, whereby the used technology is reliable and preferable.

Unlike the known methods, the method of the invention can be applied to detect the elimination of two- and three-phase faults during the dead time of auto-reclosing also in connection with a three-phase switch operation. In a simple way, the solution of the invention also takes the effect of motor loads into account by permitting the auto-reclosing to take place only after the fault has disappeared or voltages generated by the motors have decreased so much that the disappearance of electric arc faults becomes possible.

Unlike the known methods used to disconnect the faulty line section, the solution of the invention enables the rapid disconnection of the faulty line section by means of local automatics without a need for fast signalling systems. The solution of the invention does not, unlike the method based on the calculation of the fault section, require the knowledge of line parameters nor accurate current and voltage measurements. Only the measurements of voltages are needed, but they do not have to be accurate in order to be able to detect whether the fault has disappeared from the line section concerned.

The invention further relates to a method according to independent claim 10. According to the method, parameters based on voltages are formed from the voltages affecting on both sides of a switching device.

The invention further relates to a protective relay according to independent claim 15. By means of the protective relay, the advantages provided by the method of the invention can be achieved by means of a simple and reliable structure.

The invention further relates to a protective relay according to independent claim 16, by which protective relay the advantages provided by the method of independent claim 10 are achieved by means of a simple structure.

BRIEF DESCRIPTION OF THE DRAWINGS

The invention is now described in greater detail in connection with the preferred embodiments with reference to the attached drawings, in which

Figure 1 shows phase voltages of an electrical power network measured from a line during a two-phase short circuit:

Figure 2 shows main voltages of an electrical power network measured from a line during a two-phase short circuit:

Figure 3 shows the zero voltage of an electrical power network measured from a line during a phase-to-earth fault;

Figure 4 shows phase voltages of an electrical power network measured from a line during a phase-to-earth fault; and

Figure 5 shows main voltages of an electrical power network measured from a line during a three-phase short circuit.

DETAILED DESCRIPTION OF THE INVENTION

When a voltage feed is switched off from a line or line section, the line or line section does not immediately become dead, since motor loads loading the line function as generators inducing alternating voltages to the line.

In accordance with the method of the invention, a fault is detected on a line or line section of an electrical power network. The fault can be e.g. a short circuit or an earth fault which affects the normal operation of the electrical power network. As the fault is detected on the line or line section, the faulty section is disconnected from the other network, i.e. the faulty section is separated. The disconnection takes place in a protective relay or in a switching device in connection with it, which may be a mechanical switching element or a semiconductor switch, for example.

According to the method of the invention, after the fault detection and the disconnection of the faulty network section, voltage is measured from the disconnected line or line section. Voltage is measured by means of a voltage determination element adapted to the protective relay or to its connection. According to the invention voltage is thus measured from a disconnected line or line section. From the measured voltages, parameters describing the state of the disconnected section are formed. The parameters are formed in a processing element of the protective relay, which processing element is in connection with the voltage determination element.

After the parameters have been formed, the processing element concludes, on the basis of the parameters, the disappearance or possibility of disappearance of the fault of the disconnected line or line section. The parameters are formed according to the preferred embodiment of the invention in such a manner that the amplitude magnitude of a fundamental-frequency component of one or more phase or main voltages of the disconnected line or line section is determined. The forming of parameters may further comprise the step of comparing predetermined amplitude magnitudes with each other.

After the disappearance or possibility of disappearance of the fault is determined on the basis of the parameters, the line or line section disconnected according to the preferred embodiment of the invention is reconnected to the network after a predetermined time has passed.

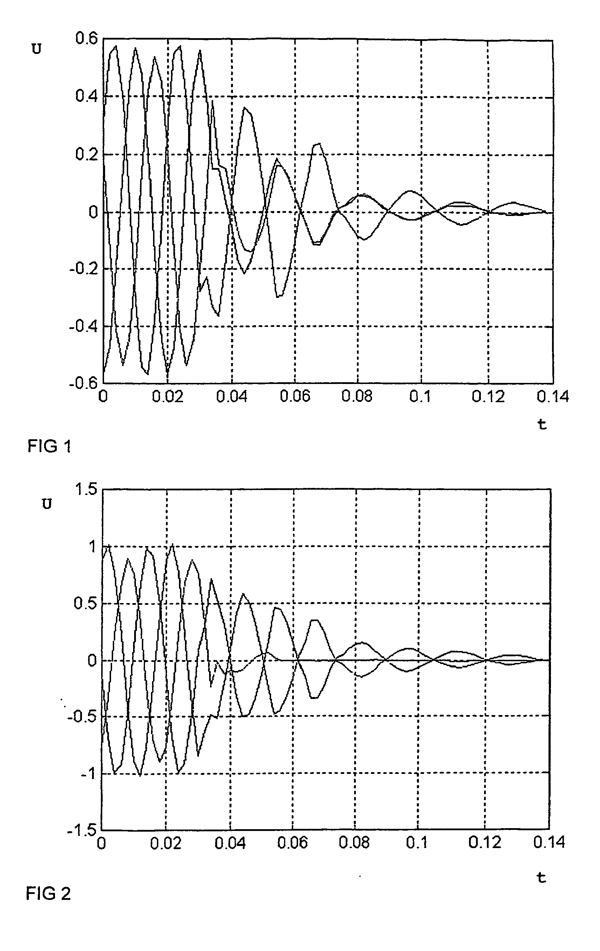

Figures 1 and 2 show examples of the voltage behaviour of a line or line section disconnected from the network in a situation in which the fault does not disappear while the switch is open. Figure 1 shows phase voltages measured from the line after the line has been disconnected as a result of a two-phase short circuit. The switch opens approximately at the instant 0.03 s, but the short circuit between the two phases does not disappear immediately. The voltages of the faulty phases follow each other, which indicates that the fault is still affecting.

Figure 2 shows main voltages measured from the line after the line has been disconnected as a result of a two-phase short circuit. The switch opens approximately at the instant 0.03 s, but the short circuit between the two phases does not disappear immediately. Since one main voltage remains low, this means that two phases are still in a short circuit. The main voltages of the figure relate to the phase voltages of Figure 1.

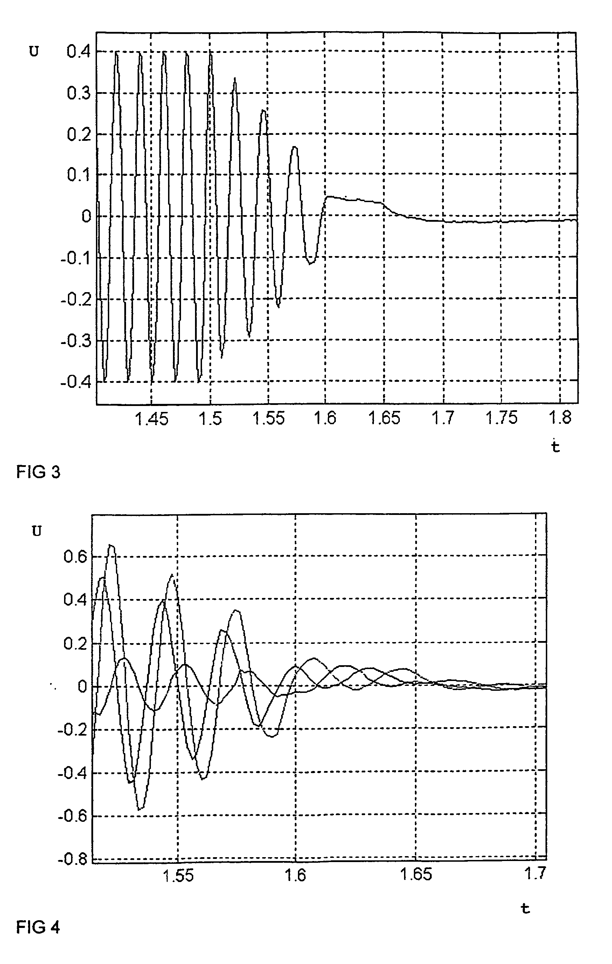

If the fault disappears while the switch is open, voltages change their nature. Examples of this are shown in Figures 3 and 4. Zero voltage, which means the sum of phase voltages as such or multiplied by a constant, becomes a low-frequency voltage as the fault disappears. The low frequency is determined by the natural frequency of the resonant circuit formed by the inductances and capacitances of the line. The phase voltages relating to the corresponding situation are shown in Figure 4. At first, the voltage of the faulty phase is clearly the lowest, but as the fault disappears, all phase voltages are approximately of the same magnitude.

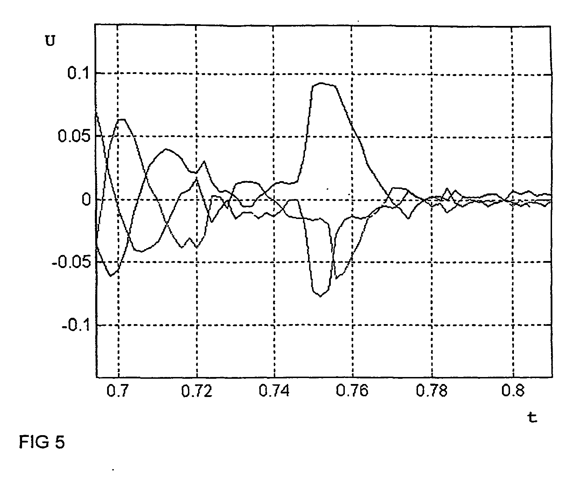

Figure 5 relates to the disappearance of a three-phase short circuit after the opening of the switch. All main voltages increase rapidly, when the short circuit disappears.

The damping of voltages in Figures 1 to 5 is caused by the fact that cage induction motors functioning as loads on the line cannot maintain the voltage, because the magnetization current derived from the natural capacitances of the line is not sufficient for the motors. The decrease in the frequency, for its part, is caused by the retardation of the motors functioning as loads, as the power feed exits.

If the fault does not disappear when the switch opens, the nature of voltages behind the open switch depends on the fault type. In a two-phase short circuit the voltage between faulty phases is very low compared with other main voltages. This kind of a situation is illustrated in Figure 2. If the two-phase fault disappears, the main voltage between the faulty phases increases to the same level as that of other main voltages.

The existence of a phase-to-earth fault also after the switch has opened can be concluded from the fact that the zero voltage remains high and the voltage of the faulty phase remains low compared with other phase voltages. When the earth fault disappears, the amplitude and frequency of the zero voltage decrease and the voltage of the faulty phase becomes as high as other phase voltages. Both the existence and the disappearance of the fault later on can be seen from Figures 3 and 4, in which the switch opens at the instant 1.5 s and the earth fault remains until the instant 1.6 s. Figure 4 shows phase voltages measured from the line after the line has been disconnected as a result of a phase-to-earth fault.

Figure 5 shows main voltages measured from the line after the line has been disconnected as a result of a three-phase short circuit. The switch opens approximately at the instant 0.68 s, but the short circuit disappears only at the instant 0.75 s, which can be seen as a sudden increase in the main voltages.

A parameter according to the method of the invention is, for example, a relation of the amplitude of a fundamental frequency component of the main voltage between the phases in a two-phase short circuit to the amplitude of a fundamental-frequency component of the highest main or phase voltage. The disappearance of the two-phase short circuit can be concluded from the fact that the voltages of the faulty phases are no longer the same. In the solution of the invention, the disappearance of the two-phase fault can be detected without any switching measures and by utilizing the measurements of the voltages induced by a motor load.

Another possible parameter is formed by the amplitudes of all fundamental frequency components of the phase or main voltages or the amplitude and frequency of the component having the greatest amplitude in the frequency spectrum of all phase or main voltages. The disappearance of the three-phase short circuit is manifested in the sudden rise in all phase or main voltages.

A parameter may also be the biggest instantaneous value of all phase and main voltages, the frequency of the component having the greatest amplitude in the frequency spectrum of the zero voltage or the time between two successive sign reversal points of the zero voltage.

The disappearance of a phase-to-earth fault can be detected by the method of the invention on the basis of the following criteria. The earth fault has disappeared, if the frequency of the component having the greatest amplitude in the frequency spectrum of the zero voltage goes below a predetermined limit, or if the time between two successive sign reversal points of the zero voltage exceeds a predetermined limit. The criteria for detecting the disappearance of a phase-to-earth fault can also be applied to detect the absence or disappearance of a ground contact in connection with two-phase and three-phase faults. By means of these conclusions, the safety of people can be improved considerably.

When voltages on the line or line section have decreased below a certain limit, there exists favourable conditions for a fault to disappear. It is already known that motor loads on the line generate alternating voltages to the line, and that they retard the disappearance of the fault during the dead time of the auto-reclosing. According to the method of the invention, these voltages are measured from the line, whereby it can be immediately detected when the favourable conditions for the disappearance of the fault are created in the prevailing connection situation of loads. The load situation varies, and when the traditional solution is employed, the dead time of the auto-reclosing has to be selected according to the connection situation having the greatest motor load and the slowest voltage damping, which leads to a gratuitously long dead time for other connection situations.

When it is detected that the fault has disappeared or that there are favourable conditions for the disappearance of the fault due to the decreased voltages, the same or a different feed can be switched on according to a preferred embodiment of the invention at the substation or disconnector satellite substation of the distribution network. If the fault disappeared immediately when the switch opened, the fault was on the feed side, when it is better to change the feed. And if the fault disappeared only some time after the switch opened, the fault was not on the feed side, and the same feed can safely be switched on again. If it cannot be detected that the fault has disappeared, the switch is not connected at all for safety reasons or one of the supplies can be switched on after a predetermined time has passed since the conditions for the disappearance of the fault were created.

On the basis of voltage measurements and the parameters based on them, a faulty line section can be disconnected from the network by means of disconnectors controlled by local automatics. In this case, the voltage measurements and the conclusions based on them are made separately for the line sections located on different sides of the disconnector. The disconnector is opened, when the parameters calculated from the voltages indicate that the fault was produced in the electrical power network. Then the disconnector is rapidly reclosed, if the voltages on both sides of the disconnector indicate that there is not a fault on said line sections. The disconnector can be closed already during the dead time of the high speed automatic reclosing, whereby another auto-reclosing and phased closings of the disconnectors need not be performed at all, and there will be no other relay operation nor an interruption in the feed resulting thereof As a result there is a considerably shorter interruption in the distribution than in the traditional method based on local logic.

The method of the invention can basically be also employed in auto-reclosings that are made in connection with earth faults of an underground system, if it is detected that by employing the method of the invention the earth fault has disappeared. The method also enables a rapid return of the feed at the substation, switching substation or disconnector satellite substation also when the fault is located behind the opened switch, but it disappears when the switch opens. The information on the disappearance of the fault is not available in the traditional solutions, and the rapid feed return would require risk-taking.

By using feed change automatics utilizing the known over-current locking the solution of the invention may create an additional criterion for detecting the disappearance of the fault. The solution of the invention can thus be employed to support the known method for improving reliability.

The method of the invention requires the measurement of voltage from the line behind the switch connected to the protective relay, and not from the busbar system, as usual. Then an additional voltage measuring device is needed to implement the auto-reclosing relaying according to the invention, the voltage measuring device measuring the voltage behind the switch. On the other hand, more and more voltage detectors or sensors behind the switch are also used in other purposes, whereby the solution of the invention does not cause extra costs. In many new switchgear the voltage measurement from each line behind the switch is already a standard solution. Further, it is to be noted that the solution of the invention applied to feed change relaying of sub-stations and switching stations operates specifically by means of the measurements of busbar voltages, whereby no additional voltage measuring devices are required.

According to an embodiment of the invention, the protective relay do not perform an auto-reclosing at all, unless it can be detected that the fault has disappeared during the time when the voltages behind the switch still exceed a predetermined level, whereby the fault is interpreted to be permanent.

The method of the invention can be applied for example in such a manner that the auto-reclosing is not made after the predetermined time has passed since the fault has disappeared, but it is waited until the voltages on both sides of the switch are in the same phase. This variation requires that at least one main voltage or phase voltage is measured before the switch, if the length of the dead time of the auto-reclosing is longer than a few seconds. If the dead time of the auto-reclosing is short, the voltages on the network side of the switch can be supposed to remain approximately in the same phases until the auto-reclosing is made. The relay may thus store the phase angles of the voltages measured before the switch has opened in memory and make the auto-reclosing at the moment when the phase angles of the voltages measured behind the open switch after the disappearance of the fault are the same as the phase angles stored in the memory. If the network frequency differs from the nominal value, then the voltage phasors measured by means of the known recursive Fourier filter rotate at the angular frequency of $\omega = 2 * \pi * (f -$ . Thus, the relay measures the frequency before the switch opens and changes the phase angles stored in the memory according to the above mentioned rotating frequency and calculates the estimates for the phase angles of the voltages on the network side of the open switch.

In many cases, the disappearance of an earth fault can be detected by measuring one phase voltage, since the low-frequency zero voltage generated when the fault disappears is high in comparison with the fundamental-frequency phase voltages generated by the motors functioning as loads. The low-frequency zero voltage is summed to the fundamental-frequency voltage causing the time between the successive zero points to often become longer. The disappearance of the earth fault can thus also be detected by measuring the time between the successive zero points of one phase voltage. If it exceeds the determined limit, the earth fault is interpreted to have disappeared.

The most preferable alternative in case of short circuits is to permit an auto-reclosing, when it is detected that the fault has disappeared, or the voltage has decreased so low that it is likely that the electric arc fault disappears. The electric arc may be lit between the faulty phases so long that the voltages are high enough to be measured. It is not thus always possible to detect the disappearance of the short circuit fault during the time that the voltages behind the open switch decrease. If the auto-reclosing were not made, unless it can be detected that the fault has disappeared, the auto-reclosing would not be made at all in many such cases in which the fault only disappears after the voltage has decreased considerably.

In case of earth faults, the most preferable alternative depends on what kind of impedances between phase conductors and the earth there are on the line behind the open switch and how harmful an unsuccessful auto-reclosing against the earth fault is regarded to be. If the impedances between the phase conductors on the line and the earth enable a sufficiently great earth fault current on a disconnected line, the electric arc of the earth fault may be lit so long that the voltages behind the switch are sufficiently high to be measured. It is thus not always possible to detect the disappearance of the earth fault during the time the voltages behind the open switch decrease.

If the impedances between the phases of the line and the earth do not allow a considerable earth fault current on the disconnected line, the electric arc of the earth fault quenches and it is most likely that the fault disappears rapidly after the switch opens. The earth fault current usually decreases after the switch has opened so much that the electric arc quenches immediately. In such a case, it is preferable not to make auto-reclosings, unless it can be detected that the fault has disappeared. If the ground contact is maintained with a very low current, then it most likely deals with a permanent fault.

If an unsuccessful auto-reclosing on the earth fault is considered to be a big danger for humans and animals, it is most preferable, regardless of the nature of the earthing system, not to make auto-reclosings, unless it can be detected that the earth fault has disappeared after the switch has opened.

To minimise network interferences, it is most preferable to make the auto-reclosing at the moment the voltages on both sides of the switch are at the same phase.

It is obvious to a person skilled in the art that as the technology develops, the basic idea of the invention can be implemented in a variety of ways. The invention and its embodiments do not thus restrict to the above examples, but they may vary in the scope of the claims.

**Claims**

1. A method in connection with a protective relay, the protective relay being connected to an electrical power network, the method comprising the steps of:

   detecting a fault on a line, line section or busbar of the electrical power network, and disconnecting the faulty line, line section or busbar in three pleases, **characterized by** further comprising the steps of:

   measuring voltages from the disconnected line, line section or busbar in three phases, forming parameters describing the state of the disconnected line, line section or busbar from the measured voltages, and concluding, on the basis of the parameters, the disappearance or possibility of disappearance of the fault of the disconnected line, line section or busbar.

2. A method as claimed in claim 1, **characterized by** further comprising the step of connecting the disconnected line, line section or busbar when a predetermined time has passed after the disappearance of the fault or the appearance of the possibility of disappearance of the fault.

3. A method as claimed in claim 1, **characterized by** further comprising the step of connecting the same or a different feed to the line, line section or busbar disconnected at a high-voltage substation or disconnector satellite substation of the electrical power network when a predetermined time has passed after the disappearance of the fault or the appearance of the possibility of disappearance of the fault.

4. A method as claimed in any one of the preceding claim 1 to 3, **characterized by** the forming of the parameters describing the state of the disconnected line, line section or busbar comprising the step of determining the amplitude magnitude of a fundamental-frequency component of one or more phase or main voltages of the disconnected line, line section or busbar.

5. A method as claimed in claim 4, **characterized by** further comprising the step of comparing the amplitude magnitudes with each other.

6. A method as claimed in any one of the preceding claims 1 to 3, **characterized by** the forming of the parameters describing the state of the disconnected line, line section or busbar comprising the step of determining the amplitude and frequency of the component having the greatest amplitude in the frequency spectrum of all phase or main voltages.

7. A method as claimed in any one of the preceding claims 1 to 3, **characterized by** the forming of the parameters describing the state of the disconnected line, line section or busbar comprising the step of determining the highest instantaneous value of all phase or main voltages of the disconnected line, line section or busbar.

8. A method as claimed in any one of the preceding claims 1 to 3, **characterized by** the forming of the parameters describing the state of the disconnected line, line section or busbar comprising the step of determining the frequency of the component having the greatest amplitude in the frequency spectrum of the zero voltage of the disconnected line, line section or busbar.

9. A method as claimed in any one of the preceding claims 1 to 3, **characterized by** the forming of the parameters describing the state of the disconnected line, line section or busbar comprising the step of determining the time between two successive sign reversal points of the zero voltage of the disconnected line, line section or busbar.

10. A method in connection with a protective relay, the protective relay being connected to an electrical power network, the method comprising the steps of:

detecting a fault in the electrical power network, and
opening a switching device on the line in three phases, the method being **characterized by** further comprising the steps of:

measuring voltages on different sides of the switching device opened in three phases, forming parameters describing the state of the line sections on different sides of the opened switching device from the measured voltages, and
concluding, on the basis of the parameters, the disappearance or possibility of disappearance of the fault or faults of the line sections.

11. A method as claimed in claim 10, **characterized by** further comprising the step of closing the switching device when a predetermined time has passed after the disappearance of the fault or faults from the line sections on different sides of the switching device or the appearance of the possibility of disappearance of the fault or faults.

12. A method as claimed in claim 10, **characterized by** further comprising the step of closing the switching device when a predetermined time has passed after it was concluded that the fault or faults have disappeared from the line sections on different sides of the switching device,

13. A method as claimed in claim 1, **characterized by** further comprising the steps of:

storing the phase angles of the voltages of the electrical power network in the memory before disconnecting the line, line section or busbar, comparing the phase angles of the voltage phasors stored in the memory with the phase angles of the measured voltages, and
connecting the line, line section or busbar after the fault has disappeared at the moment when the phase angles stored in the memory and those measured from the voltage phasors differ from each other less than what is predetermined.

14. A method as claimed in claim 13, **characterized by** further comprising the steps of:

measuring the frequency of the voltage before disconnecting the line, line section or busbar, and
changing the phase angles of the voltage stored in the memory according to the measured frequency.

15. A protective relay comprising a switching element to disconnect and connect a faulty line, line section or busbar in three phases, **characterized in tha**t the protective relay comprises:

a voltage determination element adapted to determine the magnitudes of voltages from a disconnected line, line section or busbar in three phases in an electrical power network in connection with the protective relay, and
a processing element adapted to form parameters describing the state of the disconnected line, line section or busbar from the measured voltages, and to conclude, on the basis of the parameters, the disappearance or possibility of disappearance of the fault of the disconnected line, line section or busbar.

16. A protective relay comprising a switching element to open and close a switching device of an electrical power network, **characterized in that** the protective relay further comprises:

a voltage determination element adapted to determine the magnitudes of voltages on disconnected line sections on different sides of the switching device in three phases and
a processing element adapted in connection with the voltage determination element and to form parameters describing the states of the disconnected line sections from the magnitudes of voltages on different sides of the switching device and to conclude, on the basis of the parameters, the disappearance or possibility of disappearance of the fault or faults of said line sections.

17. A protective relay as claimed in claim 15 or 16, **characterized in that** the protective relay further comprises:

a time measuring element to connect a line, line section or busbar when a predetermined time has passed after the disappearance of the fault or the appearance of the possibility of disappearance of the fault.

18. A protective relay as claimed in claim 15, **characterized in that** the protective relay further comprises:

a memory element to store the phase angles of the voltage phasors measured before the switching device opened, and

a frequency measuring element to change the phase angles stored in the memory according to the frequency.

**Patentansprüche**

1.  Verfahren im Zusammenhang mit einem Schutzrelais, welches Schutzrelais an ein elektrisches Stromnetz angeschlossen ist, wobei das Verfahren die Schritte aufweist:

    Erkennung eines Fehlers auf einer Leitung, einem Leitungsabschnitt oder einer Sammelschiene des elektrischen Stromnetzes und Abschaltung der fehlerhaften Leitung, des Leitungsabschnitts oder der Sammelschiene in drei Phasen, **dadurch gekennzeichnet, dass** es ferner die Schritte aufweist:

    Messung von Spannungen von der abgeschalteten Leitung, dem Leitungsabschnitt oder der Sammelschiene in drei Phasen, Ausbildung von Parametern, die den Zustand der abgeschalteten Leitung, des Leitungsabschnitts oder der Sammelschiene beschreiben, von den gemessenen Spannungen und Schlussfolgern des Verschwindens oder einer Möglichkeit des Verschwindens des Fehlers der abgeschalteten Leitung, des Leitungsabschnitts oder der Sammelschiene aufgrund der Parameter.

2.  Verfahren nach Anspruch 1, **gekennzeichnet durch** den weiteren Schritt der Anschaltung der abgeschalteten Leitung, des Leitungsabschnitts oder der Sammelschiene, wenn eine vorbestimmte Zeit von dem Verschwinden des Fehlers oder dem Auftreten der Möglichkeit des Verschwindens des Fehlers vergangen ist.

3.  Verfahren nach Anspruch 1, **gekennzeichnet durch** den weiteren Schritt der Verbindung derselben oder einer verschiedenen Speisung mit der Leitung, dem Leitungsabschnitt oder der Sammelschiene, die/der auf einer Hochspannungsstation oder Trennschalterstation des elektrischen Stromnetzes abgeschaltet ist, nachdem eine vorbestimmte Zeit von dem Verschwinden des Fehlers oder dem Auftreten der Möglichkeit des Verschwindens des Fehlers vergangen ist.

4.  Verfahren nach einem der vorhergehenden Ansprüche 1 bis 3, **dadurch gekennzeichnet, dass** die Ausbildung der den Zustand der abgeschalteten Leitung, des Leitungsabschnitts oder der Sammelschiene beschreibenden Parameter den Schritt aufweist, in dem die Amplitudengröße einer Grundfrequenz-Komponente einer oder mehrerer Phasen- oder Hauptspannungen der abgeschalteten Leitung, des Leitungsabschnitts oder der Sammelschiene bestimmt wird.

5.  Verfahren nach Anspruch 4, **gekennzeichnet** t durch den weiteren Schritt des Vergleichens der Amplitudengrößen miteinander.

6.  Verfahren nach einem der vorhergehenden Ansprüche 1 bis 3, **dadurch gekennzeichnet, dass** die Ausbildung der den Zustand der abgeschalteten Leitung, des Leitungsabschnitts oder der Sammelschiene beschreibenden Parameter den Schritt aufweist, in dem die Amplitude und die Frequenz der Komponente mit der höchsten Amplitude im Frequenzspektrum aller Phasen- oder Hauptspannungen bestimmt werden.

7.  Verfahren nach einem der vorhergehenden Ansprüche 1 bis 3, **dadurch gekennzeichnet, dass** die Ausbildung der den Zustand der abgeschalteten Leitung, des Leitungsabschnitts oder der Sammelschiene beschreibenden Parameter den Schritt aufweist, in dem der höchste Momentanwert von allen Phasen- oder Hauptspannungen der abgeschalteten Leitung, des Leitungsabschnitts oder der Sammelschiene bestimmt wird.

8.  Verfahren nach einem der vorhergehenden Ansprüche 1 bis 3, **dadurch gekennzeichnet, dass** die Ausbildung der den Zustand der abgeschalteten Leitung, des Leitungsabschnitts oder der Sammelschiene beschreibenden Parameter den Schritt aufweist, in dem die Frequenz der Komponente mit der höchsten Amplitude im Frequenzspektrum der Nullspannung der abgeschalteten Leitung, des Leitungsabschnitts oder der Sammelschiene bestimmt wird.

9.  Verfahren nach einem der vorhergehenden Ansprüche 1 bis 3, **dadurch gekennzeichnet, dass** die Ausbildung der den Zustand der abgeschalteten Leitung, des Leitungsabschnitts oder der Sammelschiene beschreibenden Parameter den Schritt aufweist, in dem die Zeit zwischen zwei aufeinanderfolgenden Zeichenumkehrpunkten der Nullspannung der abgeschalteten Leitung, des Leitungsabschnitts oder der Sammelschiene bestimmt wird.

10. Verfahren im Zusammenhang mit einem Schutzrelais, welches Schutzrelais an ein elektrisches Stromnetz angeschlossen ist, wobei das Verfahren die Schritte aufweist:

Erkennung eines Fehlers im elektrischen Stromnetz und

Öffnen eines Schaltgeräts auf der Leitung in drei Phasen, wobei das Verfahren **dadurch gekennzeichnet ist, dass** es ferner die Schritte aufweist:

Messung von Spannungen auf verschiedenen Seiten des in drei Phasen geöffneten Schaltgeräts,

Ausbildung von Parametern, die den Zustand der Leitungsabschnitte auf verschiedenen Seiten des geöffneten Schaltgeräts beschreiben, von den gemessenen Spannungen und

Schlussfolgern des Verschwindens oder einer Möglichkeit des Verschwindens des Fehlers oder der Fehler der Leitungsabschnitte aufgrund der Parameter.

**11.** Verfahren nach Anspruch 10, **gekennzeichnet durch** den weiteren Schritt des Schließens des Schaltgeräts, nachdem eine vorbestimmte Zeit von dem Verschwinden des Fehlers oder der Fehler von den Leitungsabschnitten auf verschiedenen Seiten des Schaltgeräts oder dem Auftreten der Möglichkeit des Verschwindens des Fehlers oder der Fehler vergangen ist.

**12.** Verfahren nach Anspruch 10, **gekennzeichnet durch** den weiteren Schritt des Schließens des Schaltgeräts, nachdem eine vorbestimmte Zeit von dem Schlussfolgern vergangen ist, dass der Fehler oder die Fehler von den Leitungsabschnitten auf verschiedenen Seiten des Schaltgeräts verschwunden sind.

**13.** Verfahren nach Anspruch 1, **dadurch gekennzeichnet, dass** es ferner die Schritte aufweist:

Speicherung der Phasenwinkel der Spannungen des elektrischen Stromnetzes im Speicher, bevor die Leitung, der Leitungsabschnitt oder die Sammelschiene abgeschaltet wird,

Vergleichen der im Speicher gespeicherten Phasenwinkel der Spannungszeiger mit den Phasenwinkeln der gemessenen Spannungen und

Kopplung der Leitung, des Leitungsabschnitts oder der Sammelschiene, nachdem der Fehler verschwunden ist, in dem Moment, wo die im Speicher gespeicherten Phasenwinkel und die von den Spannungszeigern gemessenen Phasenwinkel weniger voneinander abweichen, als vorbestimmt war.

**14.** Verfahren nach Anspruch 13, **dadurch gekennzeichnet, dass** es ferner die Schritte aufweist:

Messung der Frequenz der Spannung, bevor die Leitung, der Leitungsabschnitt oder die Sammelschiene abgeschaltet wird und

Ändern der im Speicher gespeicherten Phasenwinkel der Spannung nach der gemessenen Frequenz.

**15.** Schutzrelais mit einem Schaltelement zum Abschalten und Anschalten einer fehlerhaften Leitung, eines Leitungsabschnitts oder einer Sammelschiene in drei Phasen, **dadurch gekennzeichnet, dass** das Schutzrelais aufweist:

ein Spannungsbestimmungselement, das angeordnet ist, die Größen von Spannungen von einer abgeschalteten Leitung, einem Leitungsabschnitt oder einer Sammelschiene in drei Phasen in einem elektrischen Stromnetz im Zusammenhang mit dem Schutzrelais zu bestimmen, und

ein Verarbeitungselement, das angeordnet ist, den Zustand der abgeschalteten Leitung, des Leitungsabschnitts oder der Sammelschiene beschreibende Parameter von den gemessenen Spannungen auszubilden und aufgrund der Parameter das Verschwinden oder eine Möglichkeit des Verschwindens des Fehlers der abgeschalteten Leitung, des Leitungsabschnitts oder der Sammelschiene schlusszufolgern.

**16.** Schutzrelais mit einem Schaltelement zum Öffnen und Schließen eines Schaltgeräts eines elektrischen Stromnetzes, **dadurch gekennzeichnet, dass** das Schutzrelais ferner aufweist:

ein Spannungsbestimmungselement, das angeordnet ist, die Größen von Spannungen auf abgeschalteten Leitungsabschnitten auf verschiedenen Seiten des Schaltgeräts in drei Phasen zu bestimmen, und

ein Verarbeitungselement, das im Zusammenhang mit dem Spannungsbestimmungselement vorgesehen ist und angeordnet ist, die Zustände der abgeschalteten Leitungsabschnitte beschreibende Parameter von den Größen von Spannungen auf verschiedenen Seiten des Schaltgeräts auszubilden und aufgrund der Parameter das Verschwinden oder eine Möglichkeit des Verschwindens des Fehlers oder der Fehler der besagten Leitungsabschnitte schlusszufolgern.

**17.** Schutzrelais nach Anspruch 15 oder 16, **dadurch gekennzeichnet, dass** das Schutzrelais ferner aufweist:

ein Zeitmesselement zur Anschaltung einer Leitung, eines Leitungsabschnitts oder einer Sammelschiene, nachdem eine vorbestimmte Zeit von dem Verschwinden des Fehlers oder dem Auftreten der Möglichkeit des Verschwindens des Fehlers vergangen ist.

18. Schutzrelais nach Anspruch 15, **dadurch gekennzeichnet, dass** das Schutzrelais ferner aufweist:

ein Speicherelement zum Speichern der vor dem Öffnen des Schaltgeräts gemessenen Phasenwinkel der Spannungszeiger und
ein Frequenzmesselement zum Ändern der im Speicher gespeicherten Phasenwinkel nach der gemessenen Frequenz.

**Revendications**

1. Méthode utilisée en relation avec un relais de protection, le relais de protection étant connecté à un réseau de puissance électrique, la méthode comprenant les étapes consistant à :

détecter un défaut sur une ligne, section de ligne ou bus du réseau de puissance électrique, et déconnecter la ligne, section de ligne ou bus triphasé défectueux,

**caractérisée en ce qu'**elle comporte en outre les étapes consistant à :

mesurer des tensions de la ligne, section de ligne ou bus triphasé déconnecté,
établir des paramètres décrivant l'état de la ligne, section de ligne ou bus déconnecté à partir des tensions mesurées,
conclure, sur la base des paramètres, sur la disparition ou la possibilité de disparition du défaut de la ligne, section de ligne ou bus déconnecté.

2. Méthode selon la revendication 1, **caractérisée en ce qu'**elle comprend en outre l'étape consistant à connecter la ligne, section de ligne ou bus déconnecté quand un temps prédéterminé s'est écoulé après la disparition du défaut ou l'apparition de la possibilité d'une disparition du défaut.

3. Méthode selon la revendication 1, **caractérisée en ce qu'**elle comprend en outre l'étape consistant à connecter la même ou une différente alimentation à la ligne, section de ligne ou bus déconnecté à une sous-station à haute tension ou à une sous-station satellite déconnecteur du réseau de puissance électrique quand un temps prédéterminé s'est écoulé après la disparition du défaut ou l'apparition de la possibilité d'une disparition du défaut.

4. Méthode selon l'une quelconque des revendications 1 à 3 précédentes, **caractérisée en ce que** l'établissement des paramètres décrivant l'état de la ligne, section de ligne ou bus déconnecté comprend l'étape consistant à déterminer la valeur de l'amplitude d'une composante en fréquence fondamentale d'au moins une phase ou tensions principales de la ligne, section de ligne ou bus déconnecté.

5. Méthode selon la revendication 4, **caractérisée en ce qu'**elle comprend en outre l'étape consistant à comparer entre elles les valeurs d'amplitudes.

6. Méthode selon l'une quelconque des revendications 1 à 3 précédentes, **caractérisée en ce que** l'établissement des paramètres décrivant l'état de la ligne, section de ligne ou bus déconnecté comprend l'étape consistant à déterminer l'amplitude et la fréquence de la composante ayant la plus grande amplitude dans le spectre de fréquence de toutes les tensions de phase ou de conducteurs principaux.

7. Méthode selon l'une quelconque des revendications 1 à 3 précédentes, **caractérisée en ce que** l'établissement des paramètres décrivant l'état de la ligne, section de ligne ou bus déconnecté comprend l'étape consistant à déterminer la plus haute valeur instantanée de toutes les tensions de phase ou de conducteurs principaux de la ligne, section de ligne ou bus déconnecté.

8. Méthode selon l'une quelconque des revendications 1 à 3 précédentes, **caractérisée en ce que** l'établissement des paramètres décrivant l'état de la ligne, section de ligne ou bus déconnecté comprend l'étape consistant à déterminer la fréquence de la composante ayant la plus grande amplitude dans le spectre de fréquence de tension nulle de la ligne, section de ligne ou bus déconnecté.

9. Méthode selon l'une quelconque des revendications 1 à 3 précédentes, **caractérisée en ce que** l'établissement des paramètres décrivant l'état de la ligne, section de ligne ou bus déconnecté comprend l'étape consistant à déterminer entre deux points successifs de changement de signe du tension nulle de la ligne, section de ligne ou bus déconnecté.

10. Méthode utilisée en relation avec un relais de protection, le relais de protection étant connecté à un réseau de puissance électrique, la méthode comprenant les étapes consistant à :

détecter un défaut dans le réseau de puissance électrique, et
ouvrir un dispositif de commutation sur la ligne triphasée,

la méthode étant **caractérisée en ce qu'**elle comporte en outre les étapes consistant à :

mesurer des tensions de différents côtés du dispositif de commutation ouvert sur trois phases, établir des paramètres décrivant l'état des sections de ligne de différents côtés du dispositif de commutation ouvert à partir des tensions mesurées, conclure, sur la base des paramètres, sur la disparition ou la possibilité de disparition du défaut ou des défauts sur les sections de ligne.

11. Méthode selon la revendication 10, **caractérisée en ce qu'**elle comprend en outre l'étape consistant à fermer le dispositif de commutation quand un temps prédéterminé s'est écoulé après la disparition du défaut ou des défauts des sections de ligne de différents côtés du dispositif de commutation ou l'apparition de la possibilité d'une disparition du défaut ou des défauts.

12. Méthode selon la revendication 10, **caractérisée en ce qu'**elle comprend en outre l'étape consistant à fermer le dispositif de commutation quand un temps prédéterminé s'est écoulé après qu'il a été conclu que le défaut ou les défauts ont disparu des sections de ligne de différents côtés du dispositif de commutation.

13. Méthode selon la revendication 1, **caractérisée en ce qu'**elle comprend en outre les étapes consistant à :

stocker les angles de phase des tensions du réseau de puissance électrique dans une mémoire avant de déconnecter la ligne, section de ligne ou bus, comparer les angles de phase des phaseurs de tensions stockés dans la mémoire avec les angles de phase des tensions mesurées, et connecter la ligne, section de ligne ou bus après que le défaut a disparu au moment où les angles de phase stockés dans la mémoire et ceux mesurés par les phaseurs de tensions diffèrent entre eux d'une valeur inférieure à ce qui a été prédéterminé.

14. Méthode selon la revendication 13, **caractérisée en ce qu'**elle comprend en outre les étapes consistant à :

mesurer la fréquence du tension avant de déconnecter la ligne, section de ligne ou bus, et changer les angles de phase de la tension stockés dans la mémoire en fonction de la fréquence mesurée.

15. Relais de protection comprenant un élément de commutation pour déconnecter et connecter une ligne, section de ligne ou bus triphasé défectueux, **caractérisé en ce que** le relais de protection comprend :

un élément de détermination de tension adapté pour déterminer les valeurs de tensions d'une ligne, section de ligne ou bus triphasé déconnecté dans un réseau de puissance électrique utilisé en relation avec le relais de protection, un élément de calcul adapté pour déterminer des paramètres décrivant l'état de la ligne, section de ligne ou bus déconnecté à partir des tensions mesurées, et pour conclure, sur la base des paramètres, sur la disparition ou la possibilité de disparition du défaut de la ligne, section de ligne ou bus déconnecté.

16. Relais de protection comprenant un élément de commutation pour ouvrir et fermer un dispositif de commutation d'un réseau de puissance électrique, **caractérisé en ce que** le relais de protection comprend en outre :

un élément de détermination de tension adapté pour déterminer les valeurs de tensions sur des sections de ligne déconnectées sur différents côtés du dispositif de commutation triphasé, et un élément de calcul adapté, en relation avec l'élément de détermination de tension pour déterminer des paramètres décrivant les états des sections de ligne déconnectées à partir des valeurs de tensions de différents côtés du dispositif de commutation, et pour conclure, sur la base des paramètres, sur la disparition ou la possibilité de disparition du défaut ou des défauts sur lesdites sections de ligne.

17. Relais de protection selon la revendication 15 ou 16, **caractérisé en ce qu'**il comprend en outre :

un élément de mesure de temps pour connecter une ligne, section de ligne ou bus quand un temps prédéterminé s'est écoulé après la disparition du défaut ou l'apparence d'une possibilité de disparition du défaut.

18. Relais de protection selon la revendication 15, **caractérisé en ce qu'**il comprend en outre :

un élément de mémoire pour stocker les angles de phase des phaseurs de tension mesurées avant l'ouverture du dispositif de commutation, et un élément de mesure de fréquence pour changer les angles de phase stockés dans la mémoire en fonction de la fréquence.

FIG 1

FIG 2

FIG 3

FIG 4

FIG 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- SU 607305 A
- US 5805400 A
- US 5543995 A

### Non-patent literature cited in the description

- **Gardiner M. ; Ramsden J.** On-Site Experience of an Adaptive Autoreclosure Relay for HV Overhead Lines. *Developments in Power System Protection,* 25 March 1997, (434), 377-380
- **Laycock W.J.** Adaptive Reclosure of HV Overhead Lines. *IEEE Transmission and Distribution Conference Proceedings,* 1996, 471-474
- **Bo Z. Q.** A new approach to distinguish between transient and permanent faults using high frequency fault transients. *3rd International Conference on Advances in Power System Control, Operation and Management, Conf. Publ. No CP417,* 09 November 1995
- **Thorn J.S.** Feasibility of adaptive protection and control. *IEEE Transactions on Power Delivery,* July 1993, vol. 8 (3), 975-983